# EUROPÄISCHE PATENTSCHRIFT

(11) **EP 1 083 780 B1**
(45) Veröffentlichungstag und Bekanntmachung des Hinweises auf die Patenterteilung: **16.11.2005**
(21) Anmeldenummer: 00119072.7
(22) Anmeldetag: 02.09.2000
(51) Int. Cl.: H05K 5/00, B60R 16/02

(54) **Elektronisches Gerät für ein Kraftfahrzeug**
Electronic device for a motor vehicle
Dispositif électronique pour un véhicule automobile

(30) Priorität: 10.09.1999 DE 19943258
(43) Veröffentlichungstag der Anmeldung: 14.03.2001
(73) Patentinhaber: Hella KGaA Hueck & Co., 59552 Lippstadt (DE)
(72) Erfinder: Bolte, Michael, 59555 Lippstadt (DE); Passgang, Frank, 59556 Lippstadt (DE); Rupprath, Bernhard, 59556 Lippstadt (DE); Lange, Petrik, Dr., 59557 Lippstadt (DE); Reuter, Jürgen, 59609 Anröchte (DE)

(56) Entgegenhaltungen:
- EP-A- 0 516 149
- WO-A-99/00845
- DE-A- 4 419 005
- DE-A- 19 522 126
- DE-A- 19 703 304

## Beschreibung

Die vorliegende Erfindung betrifft ein elektronisches Gerät für ein Kraftfahrzeug gemäß dem Oberbegriff des Anspruchs 1.

Ein elektronisches Gerät der vorgenannten Art ist aus der internationalen Patentanmeldung WO 99/00845 A bekannt. Bei dem darin beschriebenen elektronischen Gerät sind innerhalb eines Gehäuses ein Schaltungsträger mit einer Steuerelektronik und ein metallener Verdrahtungsträger mit einer Leistungselektronik untergebracht. Der Schaltungsträger ist dabei beispielsweise als LTCC-Substrat (Low Temperatur Cofired Ceramic) ausgeführt, wohingegen der Verdrahtungsträger als DBC-Substrat (Direct Bonded Copper) ausgebildet ist. In dem Gehäuse sind weiterhin zwei Gerätestecker untergebracht, die über Bonddrähte mit dem Schaltungsträger und dem Verdrahtungsträger verbunden sind. Die Lastströme der Leistungselektronik werden bei dem elektronischen Gerät der WO 99/00845 A über den metallenen Verdrahtungsträger und nicht über den Schaltungsträger geleitet.

Ein sehr ähnliches elektronisches Gerät ist aus der europäischen Offenlegungsschrift EP-A-0 516 149 bekannt. Bei dem darin beschriebenen elektronischen Gerät sind innerhalb eines Gehäuses ein Schaltungsträger mit einer Steuerelektronik und ein metallener Verdrahtungsträger mit einer Leistungselektronik untergebracht. Der Verdrahtungsträger ist als insulated metal substrate (IMS) ausgebildet. In dem Gehäuse sind weiterhin zwei Gerätestecker untergebracht, die über Bonddrähte mit dem Schaltungsträger und dem Verdrahtungsträger verbunden sind. Die Lastströme der Leistungselektronik werden bei dem elektronischen Gerät der EP-A-0 516 149 über den metallenen Verdrahtungsträger und nicht über den Schaltungsträger geleitet.

Ein weiteres elektronisches Gerät ist aus der deutschen Offenlegungsschrift DE 44 19 005 A1 bekannt. Das darin beschriebene elektronische Gerät dient als Lastschaltungseinheit beispielsweise für eine Beleuchtungsanlage eines Kraftfahrzeuges. Bei dem darin beschriebenen Gerät sind auf einem elektronischen Verdrahtungsträger elektronische Lastschalter sowie eine diese Lastschalter ansteuernde Elektronik mit integrierten Schaltkreisen aufgebracht. Als nachteilig hierbei erweist sich, daß die derart ausgeführte Lastschaltungseinheit relativ großvolumig ist, weil der Großteil der Leiterbahnen durch den relativ grob strukturierten beispielsweise gestanzten metallenen Verdrahtungsträger vorgegeben sind.

Ein weiteres elektronisches Gerät ist aus der deutschen Offenlegungsschrift DE 195 22 126 A1 bekannt. Die darin beschriebene elektronische Lastschaltungseinheit für ein Kraftfahrzeug umfaßt elektronische Lastschalter und eine dazugehörige Ansteuerelektronik, die beide auf eine Hybridkeramik aufgebracht sind. Weiterhin sind auf diese Hybridkeramik Steckerstifte direkt aufgelötet, die ein kraftfahrzeugtypisches Steckkontaktteil ausbilden. Als nachteilig bei dieser Ausführungsform erweist sich, daß der oder die Lastschalter auf der Hybridkeramik aufgebracht sind und die von ihnen erzeugte Wärme nicht ausreichend gut abgeführt werden kann. Daher werden bei Betrieb dieses Systems aufgrund von thermisch induzierten Verspannungen unter Umständen Betriebsstörungen auftreten. Weiterhin müssen die auf der Hybridkeramik angeordneten Leiterbahnen, die den Laststrom zu den Lastschaltern leiten, sehr breit ausgelegt werden, so daß das gesamte System ebenfalls relativ großvolumig ausgeführt ist.

Das der vorliegenden Erfindung zugrundeliegende Problem ist die Schaffung eines elektronischen Geräts der eingangs genannten Art, bei dem ein optimaler Wärme-und Stromtransport von den elektronischen Lastschaltern und vom Logik- und Analogteil zu den Anschlußsteckern stattfindet. Weiterhin soll ein hinreichender mechanischer Schutz bei möglichst kleinem Raumbedarf erreicht werden.

Dies wird erfindungsgemäß durch ein elektronisches Gerät der eingangs genannten Art mit den kennzeichnenden Merkmalen des Anspruchs 1 erreicht.

Der metallene Verdrahtungsträger bildet Anschlussstecker aus. Dadurch, dass beispielsweise auf dem als Stanzgitter ausgeführten metallenen Verdrahtungsträger Anschlusskontakte gleich mitgestanzt werden, müssen nicht an dem elektronischen Gerät zusätzliche Anschlussstecker angebracht werden. Dies reduziert den Platzbedarf des erfindungsgemäßen elektronischen Gerätes.

Durch die Auftrennung von Lastströmen und Steuerströmen kann der die Steuerelektronik tragende Schaltungsträger hinsichtlich der Steuerelektronik optimiert und insbesondere auch miniaturisiert werden. Auf der anderen Seite kann der den mindestens einen elektronischen Lastschalter tragende metallene Verdrahtungsträger dahingehend optimiert werden, daß der oder die Lastschalter sehr nahe an entsprechenden Anschlußsteckern angeordnet werden, die die in den Lastschaltern erzeugte Wärme in die mit ihnen verbundenen Kabel überführen können.

Es kann erfindungsgemäß vorgesehen sein, den Schaltungsträger als, beispielsweise flexible, Leiterplatte auszuführen. Weiterhin besteht die Möglichkeit, den Schaltungsträger als Hybridkeramik oder als Multilayerkeramik, insbesondere auch als LTCC-Keramik auszuführen. Alternativ dazu kann der Schaltungsträger auch als insulated metall substrate (IMS) ausgeführt sein, wo beispielsweise als Metall Aluminium verwendet wird. Die Wahl eines entsprechenden Schaltungsträgers ist aufgrund der erfindungsgemäßen Trennung von Steuer- und Lastströmen auf einem metallenen Verdrahtungsträger und einem entsprechenden Schaltungsträger möglich je nach Anforderungen an die Steuerelektronik.

Gemäß einer bevorzugten Ausführungsform der vorliegenden Erfindung weist der metallene Verdrahtungsträger eine duroplastische Umpressung auf, welche ein Gehäuse für den mindestens einen Lastschalter des Gerätes ausbildet. Aufgrund einer derartig ausgebildeten Umpressung ergibt sich die Möglichkeit, als Lastschalter Nacktchips zu verwenden, die nicht einzeln gehäust sind. Neben einer sehr kompakten Bauweise ergibt sich dadurch auch eine bessere Wärmeableitung der direkt auf dem metallenen Verdrahtungsträger aufgebrachten ungehäusten elektronischen Lastschalter.

Gemäß einer weiteren Ausführungsform der vorliegenden Erfindung weist der metallene Verdrahtungsträger eine duroplastische Umpressung oder eine thermoplastische Umspritzung auf, die ein Gehäuse für den Verdrahtungsträger ausbilden. Es besteht hierdurch die Möglichkeit, den gesamten Verdrahtungsträger mit oder ohne Steuerelektronik unter Reinraumbedingungen zu konfigurieren und anschließend mit einem entsprechenden Gehäuse zu versehen, aus dem entsprechende Anschlußstecker herausragen. In einem weiteren Herstellungsschritt kann dann beispielsweise unter normalen Produktionsbedingungen eine entsprechende Ansteuerelektronik auf einem separaten Schaltungsträger hinzugefügt werden und/oder das ganze in ein geeignetes Gehäuse eingebracht werden. Weiterhin besteht auch die Möglichkeit, den metallenen Verdrahtungsträger mit der entsprechenden Elektronik in einem Anschlußstecker unterzubringen, so daß das erfindungsgemäße elektronische Gerät als Steckersteuergerät Verwendung finden kann, bei dem beispielsweise innerhalb eines Anschlusssteckers für eine Kraftfahrzeugbeleuchtungsanlage eine entsprechende Schalt- und Steuerlogik untergebracht ist. Gemäß einer weiteren Ausführungsform der vorliegenden Erfindung weist das Gerät mehrere metallene Verdrahtungsträger auf.

Diese können beispielsweise in mehreren Ebenen angeordnet sein. Hierbei besteht die Möglichkeit, die Lastschalter und die diesen Lastschaltern zugehörige Elektronik auf in unterschiedlichen Ebenen befindlichen separaten Verdrahtungsträgern anzuordnen. Das Vorsehen beispielsweise zweier Verdrahtungsträgern in zwei Ebenen bietet den Vorteil, daß die recht beträchtliche Anzahl von Anschlußkontakten, die beispielsweise bei einer Kraftfahrzeugbeleuchtungsanlage vorgesehen sein müssen, auf möglichst kleinem Raum in zwei übereinander angeordneten Ebenen unterzubringen. Weiterhin besteht bei dem separaten Unterbringen von Elektronik und Lastschaltern auf zwei unterschiedlichen Verdrahtungsträgern die Möglichkeit, den mit Lastschaltern versehenen Verdrahtungsträger nach dem Aufbringen der beispielsweise als Nacktchips ausgeführten Lastschalter mit einem entsprechendem durch Umpressung oder Umspritzung erzeugten Gehäuse zu versehen und erst anschließend in das beispielsweise als Steckersteuergerät ausgeführte erfindungsgemäße elektronische Gerät einzubauen.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: eine Draufsicht auf eine Ausführungsform eines erfindungsgemäßen elektronischen Gerätes;
- Fig. 2: eine Seitenansicht der in Fig. 1 abgebildeten Ausführungsform;
- Fig. 3: eine Seitenansicht einer weiteren Ausführungsform eines erfindungsgemäßen elektronischen Gerätes;
- Fig. 4: eine Seitenansicht einer weiteren Ausführungsform eines erfindungsgemäßen elektronischen Gerätes.

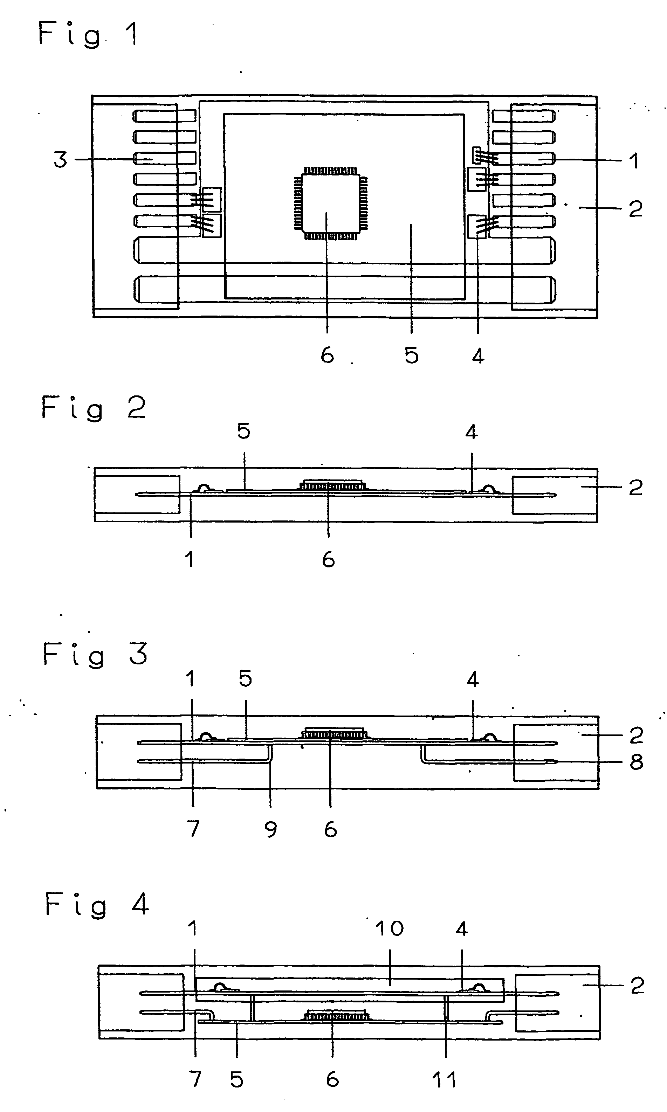

Zunächst wird die in den Fig. 1 und Fig. 2 abgebildete Ausführungsform beschrieben. Der in Fig. 1 abgebildete Teil eines erfindungsgemäßen elektronischen Geräts umfaßt einen metallenen Verdrahtungsträger 1, der entsprechend den Anforderungen strukturiert ist und an seinen in Fig. 1 linken und rechten Endabschnitten Anschlußstecker 2 aufweist. Der metallene Verdrahtungsträger 1 kann als beispielsweise aus Kupfer bestehendes Stanzteil ausgeführt sein, wobei zungenförmige Anschlußkontakte 3 der Anschlußstecker 2 integraler Bestandteil des gestanzten Verdrahtungsträgers 1 sind.

Wie ebenfalls aus Fig. 1 ersichtlich ist, sind direkt auf dem metallenen Verdrahtungsträger 1 elektronische Lastschalter 4 aufgebracht, die beispielsweise als nicht gehäuste Nacktchips ausgeführt sein können. Die elektronischen Lastschalter 4 sind über geeignete Verbindungsleitungen mit den durch das Stanzgitter des Verdrahtungsträgers 1 gegebenen Leiterbahnen verbunden.

Wie aus Fig. 1 und Fig. 2 ersichtlich ist, ist auf den metallenen Verdrahtungsträger 1 ein Schaltungsträger 5 aufgebracht. Der Schaltungsträger 5 kann als Leiterplatte, insbesondere flexible Leiterplatte, Hybridkeramik, Multilayerkeramik wie beispielsweise LTCC-Keramik oder aber auch als insulated metall substrate (IMS) ausgeführt sein. Der Schaltungsträger 5 kann beispielsweise als dünne Flexleiterplatte auf den beispielsweise als Kupferstecker-Leadframe ausgebildeten Verdrahtungsträger 1 auflaminiert werden.

Auf dem Schaltungsträger 5 ist in dem abgebildeten Ausführungsbeispiel ein integrierter Schaltkreis 6 aufgebracht. Der integrierte Schaltkreis 6 ist über geeignete Leiterbahnen und Verbindungskabel mit den elektronischen Lastschaltern 4 verbunden (nicht abgebildet). Neben dem abgebildeten integrierten Schaltkreis 6 können auch weitere Teile einer Steuerelektronik auf dem Schaltungsträger 5 angebracht sein. Wesentlich ist jedoch, daß die von den elektronischen Lastschaltern 4 geschalteten Ströme ausschließlich über den metallenen Verdrahtungsträger 1 fließen, wohingegen die die elektronischen Lastschalter 4 schaltenden Steuerströme ausschließlich über Leiterbahnen auf dem Schaltungsträger 5 beziehungsweise in entsprechenden Ansteuerleitungen von dem Schaltungsträger 5 zu den Lastschaltern 4 fließen.

Es besteht die Möglichkeit, den metallenen Verdrahtungsträger 1 zusammen mit den darauf angebrachten Lastschaltern 4 und dem darauf angeordneten Schaltungsträger 5 in ein beispielsweise aus einer duroplastischen Umpressung bestehendes Gehäuse einzubringen. Alternativ dazu kann auch eine thermoplastische Umspritzung gewählt werden.

Bei der in Fig. 3 abgebildeten Ausführungsform eines erfindungsgemäßen elektronischen Gerätes für ein Kraftfahrzeug ist auf einer Ebene unterhalb des ersten Verdrahtungsträgers 1 ein zweiter metallener Verdrahtungsträger 7 vorgesehen, der jeweils im Bereich der Anschlußstecker 2 zusätzliche Anschlußkontakte 8 ausbildet. Die in der in Fig. 3 unteren Ebene verlaufenden Leiterbahnen des zweiten metallenen Verdrahtungsträgers 7 werden an geeigneten Stellen als Leiterbahnenabschnitte 9 nach oben in die Ebene des ersten metallenen Verdrahtungsträgers beziehungsweise in die Ebene des Schaltungsträgers 5 überführt, um eine Verbindung der als Leistungs- oder Steueranschlüsse ausgeführten zusätzlichen Anschlußkontakte 8 mit den entsprechenden Lastschaltern 4 beziehungsweise der entsprechenden Ansteuerelektronik zu ermöglichen.

In Fig. 4 ist eine Ausführungsform eines erfindungsgemäßen elektronischen Gerätes abgebildet, bei der ebenfalls zwei in untereinanderliegenden Ebenen angeordnete metallene Verdrahtungsträger 1, 7 vorgesehen sind. Auf dem in Fig. 4 oberen oder ersten Verdrahtungsträger 1 sind wie bereits in den beiden vorbeschriebenen Ausführungsformen elektronische Lastschalter 4 aufgebracht. In dem abgebildeten Ausführungsbeispiel ist der obere Verdrahtungsträger 1 zusammen mit den darauf aufgebrachten Lastschaltern 4 mit einer duroplastischen Umpressung 10 versehen. Der untere oder zweite Verdrahtungsträger 7 ist mit einem Schaltungsträger 5 verbunden, auf dem ein integrierter Schaltkreis 6 und gegebenenfalls weitere nicht abgebildete Steuerlogik aufgebracht ist. Über geeignete Verbindungsleitungen 11 ist der Schaltungsträger 5 mit dem die Lastschalter 4 tragenden oberen Verdrahtungsträger 1 verbunden.

Es besteht gegebenenfalls auch die Möglichkeit, auf dem oberen Verdrahtungsträger 1 innerhalb der duroplastischen Umpressung 10 einen weiteren nicht abgebildeten Schaltungsträger mit einer zusätzlichen Ansteuerlogik für die Lastschalter 4 anzubringen.

## Patentansprüche

1. Elektronisches Gerät für ein Kraftfahrzeug, umfassend
- mindestens einen elektronischen Lastschalter (4), der auf einem metallenen Verdrahtungsträger (1, 7) aufgebracht ist,
- eine Elektronik, welche zumindest einen integrierten Schaltkreis (6) beinhaltet;
- einen mit dem metallenen Verdrahtungsträger (1, 7) verbundenen Schaltungsträger (5), auf dem die Elektronik angeordnet ist, wobei die Lastströme des mindestens einen elektronischen Lastschalters (4) über den metallenen Verdrahtungsträger (1, 7), nicht aber über den Schaltungsträger (5) geleitet sind;
**dadurch gekennzeichnet, dass** der metallene Verdrahtungsträger (1, 7) als Stanzgitter ausgeführt ist und Anschlussstecker (2) ausbildet, die gestanzte Anschlusskontakte (3, 8) umfassen.

2. Elektronisches Gerät nach Anspruch 1, **dadurch gekennzeichnet, daß** der Schaltungsträger (5) als Leiterplatte ausgeführt ist.

3. Elektronisches Gerät nach Anspruch 2, **dadurch gekennzeichnet, daß** der Schaltungsträger (5) als flexible Leiterplatte ausgeführt ist.

4. Elektronisches Gerät nach Anspruch 1, **dadurch gekennzeichnet, daß** der Schaltungsträger als Hybridkeramik oder als Multilayerkeramik, insbesondere als LTCC-Keramik, ausgeführt ist.

5. Elektronisches Gerät nach Anspruch 1, **dadurch gekennzeichnet, daß** der Schaltungsträger (5) als insulated metall substrate (IMS) ausgeführt ist.

6. Elektronisches Gerät nach einem der Ansprüche 1 bis 5, **dadurch gekennzeichnet, daß** der metallene Verdrahtungsträger (1, 7) eine duroplastische Umpressung (10) aufweist, welche ein Gehäuse für den mindestens einen Lastschalter (4) des Gerätes ausbildet.

7. Elektronisches Gerät nach einem der Ansprüche 1 bis 5, **dadurch gekennzeichnet, daß** der metallene Verdrahtungsträger (1, 7) eine duroplastische Umpressung oder thermoplastische Umspritzung aufweist, welche ein Gehäuse für den Verdrahtungsträger (1, 7) ausbildet.

8. Elektronisches Gerät nach einem der Ansprüche 1 bis 7, **dadurch gekennzeichnet, daß** das Gerät mehrere metallene Verdrahtungsträger (1, 7) aufweist.

9. Elektronisches Gerät nach Anspruch 8, **dadurch gekennzeichnet, daß** die metallenen Verdrahtungsträger (1, 7) in mehreren Ebenen angeordnet sind.

10. Elektronisches Gerät nach einem der Ansprüche 8 oder 9, **dadurch gekennzeichnet, daß** der mindestens eine Lastschalter (4) und die Elektronik auf separaten Verdrahtungsträgern (1, 7) angeordnet sind.

## Claims

1. Electronic device for a motor vehicle, including
• at least one electronic load switch (4) which is mounted on a metal wiring support (1, 7),
• an electronic item containing at least one integrated switch circuit (6),
• a switch support (5) which is connected to the metal wiring support and on which are arranged the electronics, and the load currents of the at least one electronic load switch (4) are ducted via the metal wiring support (1, 7), but not over the switch support,
**characterised in that** the metal wiring support (1, 7) is designed as a stamped grid and establishes connecting plugs which encase stamped connecting contacts (3, 8).

2. Electronic device according to Claim 1, **characterised in that** the switch support (5) is designed as a conductor plate.

3. Electronic device according to Claim 2, **characterised in that** the switch support (5) is designed as a flexible conductor plate.

4. Electronic device according to Claim 1, **characterised in that** the switch support is produced in hybrid ceramics or multi-layer ceramics, in particular a LTCC ceramic.

5. Electronic device according to Claim 1, **characterised in that** the switch support (5) is produced as an insulated metal substrate (IMS).

6. Electronic device according to one of Claims 1 to 5, **characterised in that** the metallic wiring support (1, 7) comprises a duroplastic encasement (10) which establishes a housing for the at least one load switch (4) of the device.

7. Electronic device according to one of Claims 1 to 5, **characterised in that** the metal wiring support (1, 7) comprises a duroplastic encasement or thermoplastic coating which establishes a housing for the wiring support (1, 7).

8. Electronic device according to one of Claims 1 to 7, **characterised in that** the device comprises a plurality of metal wiring supports (1, 7)

9. Electronic device according to Claim 8, **characterised in that** the metal wiring supports (1, 7) are arranged at a plurality of levels.

10. Electronic device according to one of Claims 8 or 9, **characterised in that** the at least load switch (4) and the electronic are arranged on separate wiring supports (1, 7).

## Revendications

1. Appareil électronique pour un véhicule automobile, comprenant
- au moins un interrupteur électronique de charge (4), qui est monté sur un support métallique de câblage (1, 7),
- une unité électronique, qui contient au moins un circuit intégré (6),
- un porte-circuits (5) qui est relié au support métallique de câblage (1, 7) et sur lequel est disposée l'unité électronique, les courants de charge du au moins un interrupteur de charge électronique (4) étant guidés par l'intermédiaire du support métallique de câblage (1, 7), mais pas au moyen du porte-circuits (5);
**caractérisé en ce que** support métallique de câblage (1, 7) est agencé sous la forme d'une grille découpée et forme des connecteurs de raccordement (2) qui comprennent des contacts de raccordement découpés (3, 8).

2. Appareil électronique selon la revendication 1, **caractérisé en ce que** le porte-circuits (5) est agencé sous la forme d'une plaquette à circuits imprimés.

3. Appareil électronique selon la revendication 2, **caractérisé en ce que** le porte-circuits (5) est agencé sous la forme d'une plaquette flexible à circuits imprimés.

4. Appareil électronique selon la revendication 1, **caractérisé en ce que** le porte-circuits est agencé sous la forme d'un élément céramique hybride ou d'un élément céramique multicouche, notamment sous la forme d'un élément céramique LTCC.

5. Appareil électronique selon la revendication 1, **caractérisé en ce que** le porte-circuits (5) est réalisé sous la forme d'un substrat métallique isolé (IMS).

6. Appareil électronique selon l'une des revendications 1 à 5, **caractérisé en ce que** le support métallique de câblage (1, 7) comprend un enveloppement pressé (10) formé d'une matière plastique durcissable, qui forme un boîtier pour le au moins un interrupteur de charge (4) de l'appareil.

7. Appareil électronique selon l'une des revendications 1 à 5, **caractérisé en ce que** le support métallique de câblage (1, 7) comporte une enveloppe serrée en matière plastique durcissable ou un enrobage thermoplastique formé par injection, qui forme un boîtier pour le support de câblage (1, 7).

8. Appareil électronique selon l'une des revendications 1 à 7, **caractérisé en ce que** l'appareil comporte plusieurs support métallique de câblage (1, 7).

9. Appareil électronique selon la revendication 8, **caractérisé en ce que** les supports métalliques de câblage (1, 7) sont disposés dans plusieurs plans.

10. Appareil électrique selon l'une des revendications 8 ou 9, **caractérisé en ce que** le au moins un interrupteur de charge (4) et l'unité électronique sont disposés sur des supports séparés de câblage (1, 7).
